# EUROPEAN PATENT APPLICATION

(11) **EP 2 388 837 A2**
(43) Date of publication of application: **23.11.2011**
(21) Application number: 11166550.1
(22) Date of filing: 18.05.2011
(51) Int. Cl.: H01L 33/48, H05B 33/08

(54) **Light emitting device package**

(30) Priority: 20.05.2010 KR 20100047586
(71) Applicant: LG Innotek Co., Ltd., Seoul 100-714 (KR)
(72) Inventor: An, Joong In, 100-714, Seoul (KR)
(74) Representative: Zardi, Marco

(57) **Abstract**

A light emitting device package is provided comprising a substrate, a first light emitting device, a body including a first lead frame on which the first light emitting device is disposed and a second lead frame separated from the first lead frame and an ESD device which contacts the first and second lead frames, and at least a part to which is exposed the outside of the body.

## Description

### CROSS-REFERENCE TO RELATED APPLICATION

This application claims the priority benefit of Korean Patent Application No. 10-2010-0047586, filed on May 20, 2010 in the Korean Intellectual Property Office, the disclosure of which is incorporated herein by reference.

### BACKGROUND OF THE EMBODIMENT

### 1. Technical Field

Embodiments are directed to a light emitting device package.

### 2. Discussion of the Related Art

As a typical example of light emitting devices, a light emitting diode (LED) is one of semiconductor devices which convert electrical energy into light, and has advantages such as low heat generation, long lifespan, rapid response time, stability and environmental friendliness, as compared with conventional light sources including an incandescent lamp, a fluorescent lamp, a halogen lamp and other discharge lamps. The light emitting diode uses a chip type semiconductor differing from the conventional light sources using heat or electric discharge.

The light emitting diode, which includes a chip having a remarkably small size, as compared with the conventional light sources, and a package body, is weak against electrostatic discharge (ESD) shock, and in order to reduce the ESD shock applied to the light emitting diode, an ESD device, such as a Zener diode, is mounted on the package body.

Recently, research on prevention of absorption or interference of light emitted from the light emitting diode by the ESD device, such as the Zener diode, has been progressing.

### SUMMARY OF THE EMBODIMENT

Embodiments provide a light emitting device package which has a simple manufacturing process, does not cause reduction of brightness due to an ESD device and has improved heat dissipation characteristics.

According to an embodiment, there is provided a light emitting device package comprising a first light emitting device, a body including a first lead frame on which the first light emitting device is disposed and a second lead frame separated from the first lead frame and an ESD device which contacts the first and second lead frames, and at least a part to which is exposed the outside of the body.

According to the embodiments, an ESD device to be disposed at the outside of a body, thereby not causing lowering of an intensity of light emitted from a light emitting device and improving heat dissipation characteristics through a heat dissipation hole formed under the light emitting device.

According to the embodiments, does not require a separate wire bonding process to connect the ESD device and the light emitting device and solders the ESD device to a substrate during a solder reflow process, thereby simplifying a manufacturing process of the light emitting device package.

### BRIEF DESCRIPTION OF THE DRAWINGS

FIG. 1 is a partial perspective view of a light emitting device package in accordance with a first embodiment;
FIG. 2 is a perspective view illustrating a structure of lead frames shown in FIG. 1;
FIGs 3 to 5 are schematic views illustrating various structures of protrusions of the light emitting device package shown in FIG. 1;
FIG. 6 is a view illustrating heat dissipation characteristics of the light emitting device package shown in FIG. 1;
FIG. 7 is a partial perspective view of a light emitting device package in accordance with a second embodiment;
FIGs. 8 and 9 are views illustrating a groove of FIG. 7, before and after an ESD device is disposed in the groove, respectively;
FIGs. 10 and 11 are views illustrating structures of the groove of FIG. 7;
FIG. 12 is a cross-sectional view of the light emitting device package along cavity inclined planes;
FIG. 13 is a view illustrating an alignment of light emitting devices in accordance with another embodiment;
FIGs. 14 to 18 are views illustrating various methods of filling a cavity with resin materials in accordance with embodiments;
FIG. 19 is a perspective view of one backlight unit including light emitting device packages in accordance with one embodiment;
FIG. 20 is a perspective view of another backlight unit including the light emitting device packages in accordance with the embodiment; and
FIG. 21 is a perspective view of a lighting apparatus including light emitting device packages in accordance with one embodiment.

### DETAILED DESCRIPTION OF THE EXEMPLARY EMBODIMENTS

Hereinafter, exemplary embodiments will be described in detail with reference to the accompanying drawings, wherein the same reference numerals are used to denote the same or substantially the same devices throughout the specification and the drawings. In the drawings, it will be understood that when a layer (or film, region, pattern, or substrate) is referred to as being 'on' or 'under' another layer (or film, region, pattern, or substrate), it can be directly on or under the other layer (or film, region, pattern, or substrate), or intervening layers may also be present.

In the drawings, the dimensions, such as sizes or thicknesses, of layers or films are exaggerated, omitted, or schematically shown for clarity of illustration. Accordingly, the sizes of the devices in the drawings do not thoroughly reflect real sizes of devices.

Angles and directions described herein are based on those shown in the drawings. Reference points of angles and locations of LED array structures, which are not clearly described herein, are based on those shown in the drawings.

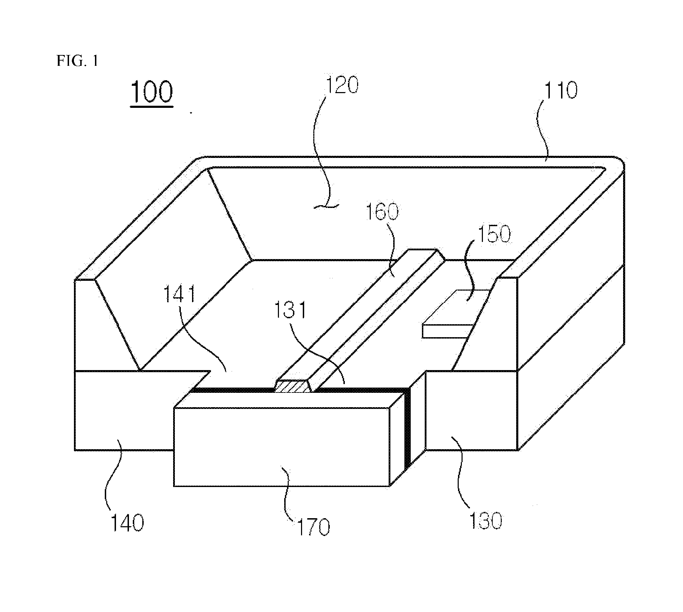

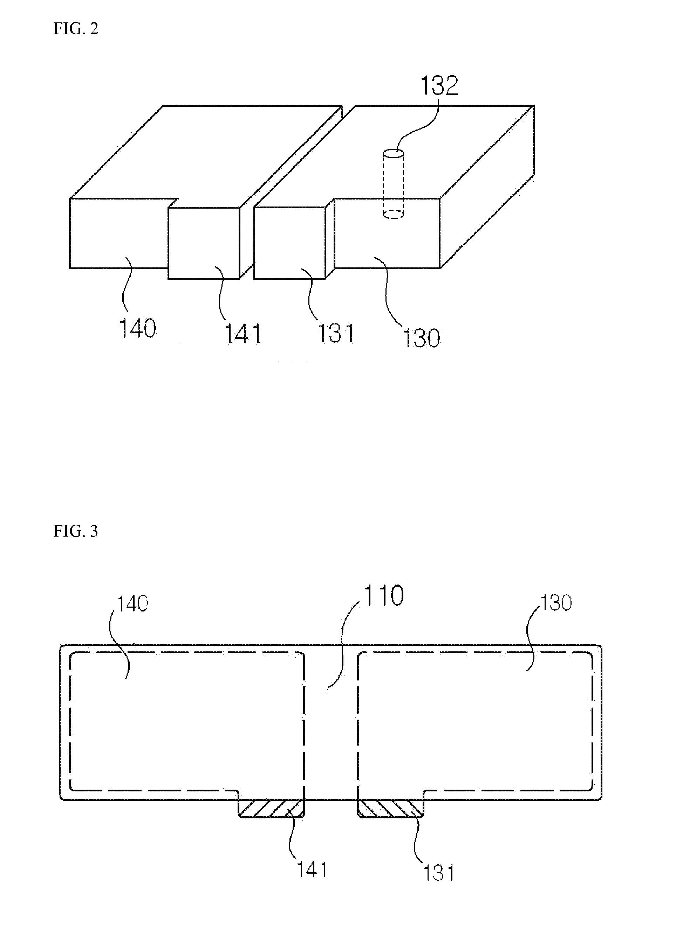

FIG. 1 is a partial perspective view of a light emitting device package in accordance with a first embodiment and FIG. 2 is a perspective view illustrating a structure of lead frames shown in FIG. 1.

FIG. 1, which is a partial perspective view of a light emitting device package 100 in accordance with the first embodiment, as seen from the top, illustrates a cross section of a portion, which is adjacent to an ESD device 170, out of a region forming a cavity 120 in a body 110 for convenience of description and understanding.

With reference to FIGs. 1 and 2, the light emitting device package 100 includes the body 110, the cavity 120 formed in the body 110, a light emitting device 150, a first lead frame 130, a second lead frame 140, a protective cap 160, and the ESD device 170.

The first and second lead frames 130 and 140 are made of a metal or a conductive material to dissipate heat generated by the light emitting device 150 directly to the outside.

The first and second lead frames 130 and 140 may be disposed on one of a metal substrate, an epoxy resin substrate, a flexible substrate, a composite substrate and a ceramic substrate, and dissipate the heat generated by the light emitting device 150 to the outside through a pattern formed on the substrate or through direct contact with the atmosphere.

If the light emitting device 150 is disposed on the first lead frame 130, a heat dissipation hole 132 is formed on the first lead frame 130.

Although this embodiment describes the light emitting device 150 as being disposed on the first lead frame 130, a light emitting device (not shown) differing from the light emitting device 150 may be disposed on the second lead frame 140.

If another light emitting device is disposed on the second lead frame 140, a heat dissipation hole (not shown) differing from the heat dissipation hole 132 may be formed on the second lead frame 140, but is not limited thereto.

Further, a plurality of heat dissipation holes may be formed on the first and second lead frames 130 and 140, but is not limited thereto.

In this embodiment, the heat dissipation hole 132 is formed on the first lead frame 130.

The heat dissipation hole 132 is formed so as to dissipate the heat generated by the light emitting device 150 to the outside. Preferably, the heat dissipation hole 132 is formed at a region of the first lead frame 130 contacting the light emitting device 150 and passes through the first lead frame 130.

Although this embodiment describes the heat dissipation hole 132 as having a circular shape, the shape of the heat dissipation hole 132 is not limited thereto. That is, the heat dissipation hole 132 may have various shapes so as to improve heat dissipation characteristics.

The first and second lead frames 130 and 140 include a first protrusion 131 and a second protrusion 141, respectively.

The first protrusion 131 formed on the first lead frame 130 and the second protrusion 141 formed on the second lead frame 140 are exposed to the outside of the body 110.

The first and second protrusions 131 and 141 may be provided with first and second side planes (not shown) which are formed in parallel with the surface of one side surface of the body 110 or are protruded from the side surface of the body 110.

Here, the first and second side planes are exposed planes of the first and second protrusions 131 and 141, and will be described as the first and second protrusions 131 and 141, hereinafter.

The ESD device 170 is soldered to the first protrusion 131 and the second protrusion 141 exposed from the body 110, and serves to stabilize power supplied to the light emitting device 150 and to prevent application of ESD to the light emitting device 150.

The ESD device 170 may be a Zener diode, a varistor or a transient voltage suppressor (TVS), and be installed at the outside of the light emitting device package 100.

The ESD device 170, which is installed at the outside of the light emitting device package 100, is not adjacent to the light emitting device 150 and thus does not interfere with and does not absorb light emitted from the light emitting device 150.

That is, the ESD device 170 does not cause loss of the light emitted from the light emitting device 150.

The first and second protrusion 131 and 141 are made of a metal or a conductive material, and thus may be soldered to the ESD device 170 by lead, silver or other soldering materials.

In this embodiment, when a solder reflow process of soldering the first lead frame 130 and the second lead frame 140 to a substrate (not shown) is performed, the ESD device 170 together with the first protrusion 131 and the second protrusion 141 is soldered to the substrate.

Such a solder reflow process means a soldering process in which, when the light emitting device package 100 in accordance with this embodiment is disposed on the substrate, a cream solder is applied to the substrate, the light emitting device package 100 is disposed on the substrate to which the cream solder is applied and then is soldered to the substrate by the molten cream solder by heat within a reflow oven.

When the light emitting device package 100 is soldered to the substrate by the solder reflow process, the ESD device 170 together with the body 110 of the light emitting device package 100 is disposed on the substrate. When the reflow process is performed, the ESD device 170 together with the first protrusion 131 and the second protrusion 141 is soldered to the substrate by the cream solder.

Therefore, the light emitting device package 100 in accordance with this embodiment does not require a wire-bonding process of the light emitting device 150 and the ESD device 170.

Further, the light emitting device package 100 in accordance with this embodiment does not require separate soldering of the ESD device 170 to the body 110.

In the light emitting device package 100 in accordance with this embodiment, when the solder reflow process is performed, the conductive first and second protrusions 131 and 141 exposed to the outside of the body 110 are soldered to electrodes of the ESD device 170.

FIGs 3 to 5 are schematic views illustrating various structures of the protrusions of the light emitting device package shown in FIG. 1.

First, with reference to FIG. 3, the protrusion 131 formed on the first lead frame 130 and the second protrusion 141 formed on the second lead frame 140 are protruded from one side surface of the main body 110 to the outside.

The body 110 is connected with the first and second lead frames 130 and 140, causes bottoms and side surfaces of the first lead frame 130 and the second lead frame 140 to be exposed to the outside so as to be soldered to a substrate (not shown) and causes the first protrusion 131 and the second protrusion 141 to be protruded to the outside so as to be soldered to the ESD device 170.

Since the bottoms of the first and second lead frames 130 and 140 are exposed to the outside of the body 110, when the first and second lead frames 130 and 140 are soldered to the substrate, heat generated by the light emitting device package 100 is dissipated through a circuit pattern formed on the substrate. Further, the heat is also dissipated by the first and second protrusions 131 and 141 protruded to the outside of the body 110.

Here, the ESD device 170 disposed at the outside of the body 110 electrically contacts the first and second protrusions 131 and 141 of the first and second lead frames 130 and 140, and heat generated by the light emitting device 150 is dissipated to the outside through the first and second lead frames 130 and 140.

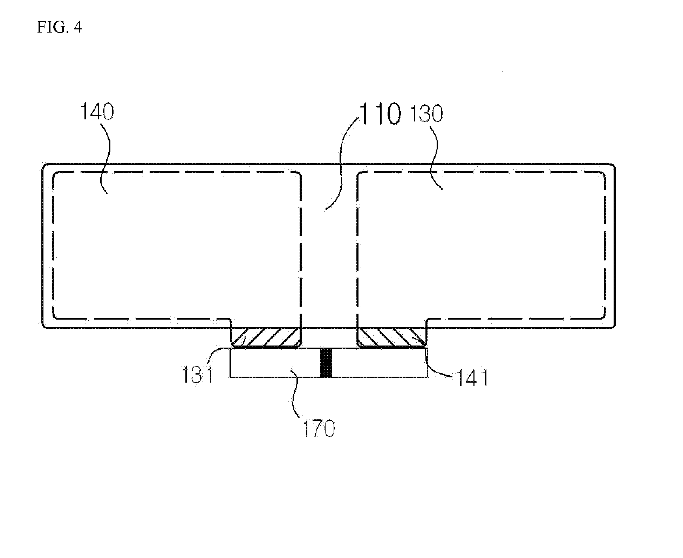

Next, FIG. 4 illustrates one example of soldering between the body 110 and the ESD device 170 shown in FIG. 3.

With reference to FIG. 4, the ESD device 170 is soldered to the first protrusion 131 and the second protrusion 141 protruded from the body 110 and is disposed on one side surface of the body 110 by such soldering.

The light emitting device package 100 in accordance with this embodiment has a T shape in which the ESD device 170 is disposed on the side surface of the body 110, as seen from the top.

In the drawings, a dotted line indicates the first and second lead frames 130 and 140 which are disposed under the body 110 and are not visible with the naked eye, as seen from the top.

Edges of the first and second protrusions 131 and 141 may be rounded.

The first and second protrusions 131 and 141, the edges of which are rounded, prevent damage to parts of the light emitting device package 100 due to interference between the parts of the light emitting device package 100 and a neighboring light emitting device package or protect a worker from injury, and prevent generation of high intensity discharge in a burn-in test.

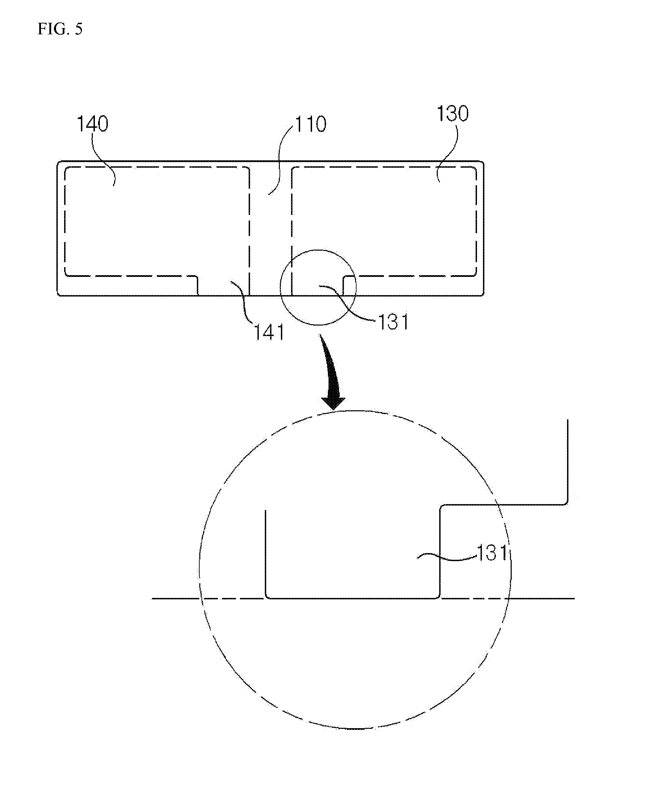

Next, FIG. 5 illustrates one example of collinear location of a first side plane (not shown) of the first protrusion 131 and a second side plane (not shown) of the second protrusion s141 with one side surface of the main body 110.

With reference to FIG. 5, the first side plane of the first protrusion 131 and the second side plane of the second protrusion 141 are not protruded from the side surface of the body 110 but are coplanar with the side surface of the body 110.

Since the first and second planes are coplanar with the outer circumferential surface of the body 110, when the body 110 is disposed on a substrate, a mount area of the substrate occupied by the body 110 is reduced.

The first and second protrusions 131 and 141 shown in FIG. 5 is also soldered to the ESD device 170, when the solder reflow process of soldering the first and second lead frames 130 and 140 to the substrate after the body 110 is disposed on the substrate.

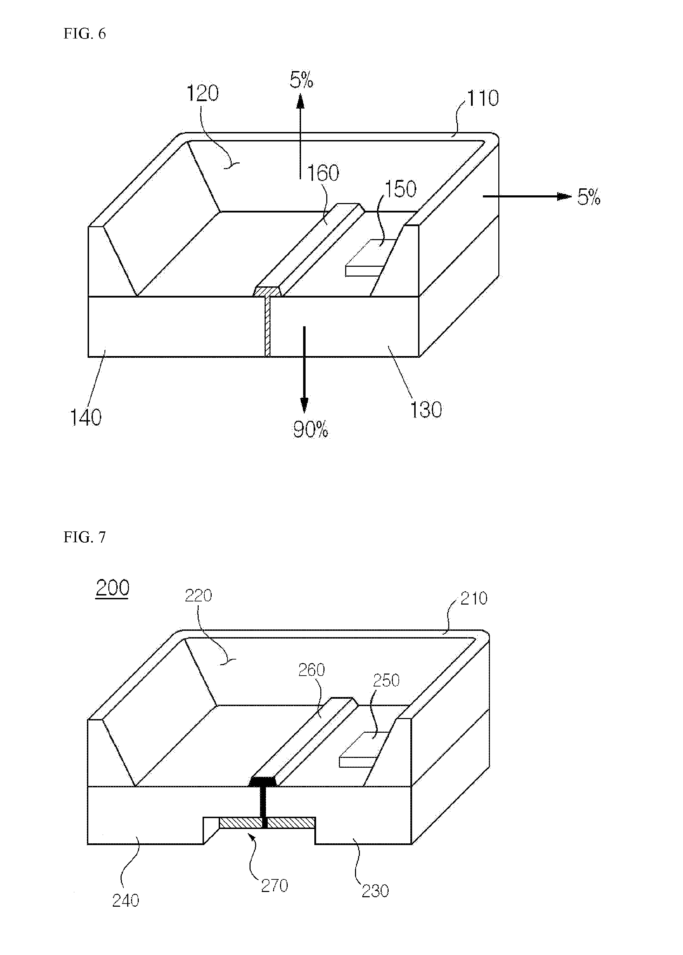

FIG. 6 is a view illustrating heat dissipation characteristics of the light emitting device package shown in FIG. 1.

FIG. 6, which is a perspective view of the light emitting device package 100 in accordance with this embodiment, as seen from the top, illustrates a cross section of a portion, in which the first and second lead frames 130 and 140 are exposed, out of a region forming the cavity 120 in the body 110 for convenience of description and understanding.

With reference to FIG. 6, the light emitting device package 100 dissipates about 5% of heat generated by the light emitting device 150 through inclined planes of the cavity 120, dissipates about 5% of the heat through an opened region formed by the cavity 120, and dissipates about 90% of the heat through the first and second lead frames 130 and 140 on which the light emitting device 150 is disposed.

The cavity 120 is filled with a resin material including a phosphor or a transparent or semitransparent resin material, and thus dissipation of the heat generated by the light emitting device 150 directly to the outside is difficult.

Further, the inclined planes of the cavity 120 are made of a resin material, such as PPE or epoxy, and thus have excessively low thermal and electrical conductivity.

On the other hand, the first lead frame 130 and the second lead frame 140 separated from the first lead frame 130 are made of a metal or a conductive material and thus have excellent thermal conductivity. Further, the first lead frame 130 and the second lead frame 140 are disposed under the light emitting device 150 and thus promptly dissipate heat generated by the light emitting device 150.

That is, the lead frame type light emitting device package 100 dissipates most of the heat generated by the light emitting device 150 through the first and second lead frames 130 and 140, and heat dissipation characteristics of the light emitting device package 100 is improved in direct proportion to increase in volume of the first and second lead frames 130 and 140.

When the ESD device 170 electrically contacts the first and second lead frames 130 and 140, first and second planes (not shown) of the ESD device 170 made of a metal and the ESD device 170 itself buffer heat, and when reflow treatment of the body 110 onto the substrate is performed, a soldering region formed by soldering the first lead frame 130 and the second lead frame 140 to the first and second planes of the ESD device 170 is used to dissipate heat generated by the light emitting device 150 and to buffer the heat, thereby improving heat dissipation characteristics of the light emitting device 150.
FIG. 7 is a partial perspective view of a light emitting device package in accordance with a second embodiment.

FIG. 7, which is a partial perspective view of a light emitting device package 200 in accordance with the second embodiment, as seen from the top, illustrates a cross section of a portion, in which first and second lead frames 230 and 240 are exposed, out of a region forming a cavity 220 in a body 210 for convenience of description and understanding.

With reference to FIG. 7, the light emitting device package 200 includes the body 210 forming the cavity 220, the first and second lead frames 230 and 240 connected with the body 210 to supply driving power to a light emitting device 250, a protective cap 260 to electrically insulate the first and second lead frames 230 and 240 from each other and to fill a gap between the first and second lead frames 230 and 240 so as to prevent dust, moisture and other foreign substances from entering the gap, and a groove 270 formed on the body 210 to expose a part of each of the first and second lead frames 230 and 240 to the outside.

The groove 270 is made by forming a trench into neighboring regions of the first and second lead frames 230 and 240.

The groove 270 is provided to solder an ESD device (not shown), such as a Zener diode, a varistor and a TVS, to a substrate through a solder reflow process after insertion of the ESD device (not shown) into the groove 270.

Therefore, the groove 270 is formed over one region of the left side of the first lead frame 230 and one region of the right side of the second lead frame 240 based on FIG. 7.

A depth of the groove 270 is determined according to a width of the ESD device proceeding to the center between the first lead frame 230 and the second lead frame 240.

For example, the groove 270 minimizes an area of the substrate occupied by the light emitting device package 200 when the ESD device is inserted into the groove 270.

Although not shown in the drawings, a heat dissipation hole (not shown) is formed at a region of the first lead frame 230 contacting the lower portion of the light emitting device 250.

The heat dissipation hole is formed on the first lead frame 230, and dissipates heat generated by the light emitting device 250 directly toward a region of the substrate contacting the first lead frame 230.

Although this embodiment describes the light emitting device 250 as being disposed on the first lead frame 230, the light emitting device 250 may also be disposed on the second lead frame 240, and if the light emitting device 250 is also disposed on the second lead frame 240, the heat dissipation hole may also be formed on the second lead frame, but is not limited thereto.

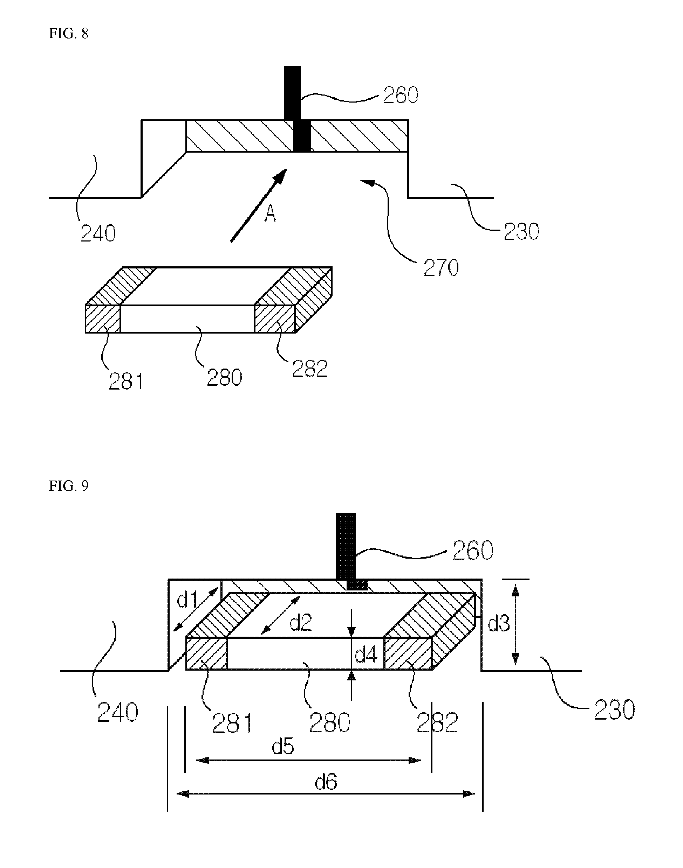

FIGs. 8 and 9 are views illustrating the groove of FIG. 7, before and after an ESD device is disposed in the groove, respectively.

With reference to FIGs. 8 and 9, an ESD device 280 is a two-terminal device and includes a pair of first and second electrodes 281 and 282. The first and second electrodes 281 and 282 are soldered to the second lead frame 240 and the first lead frame 230, respectively.

Here, the first and second electrodes 281 and 282 may be formed on first and second planes (not shown) of the ESD device 280, and the first and second planes (not shown) are not limited.

When the ESD device 280 is inserted into the groove 270 in the direction A using specialized equipment or by a worker, the ESD device 280 is disposed in the groove 270, as shown in FIG. 9.

Here, when the solder reflow process of the light emitting device package 200 is performed, the first electrode 281 and the second lead frame 240 are electrically connected by soldering and the second electrode 282 and the first lead frame 230 are electrically connected by soldering.

As described above, a size of the groove 270 is determined by a size and shape of the ESD device 280 disposed on the light emitting device package 200.

For example, assuming that the ESD device 280 has a length d5, a width d2 and a height d4, a length d6, a width d1 and a height d3 of the groove 270 may be greater than the length d5, the width d2 and the height d4 of the ESD device 280.

Although this embodiment describes the groove 270 as being formed on one side surface of the light emitting device package 200, the groove 270 is formed on a rear surface of the light emitting device package 200 but is not limited thereto.

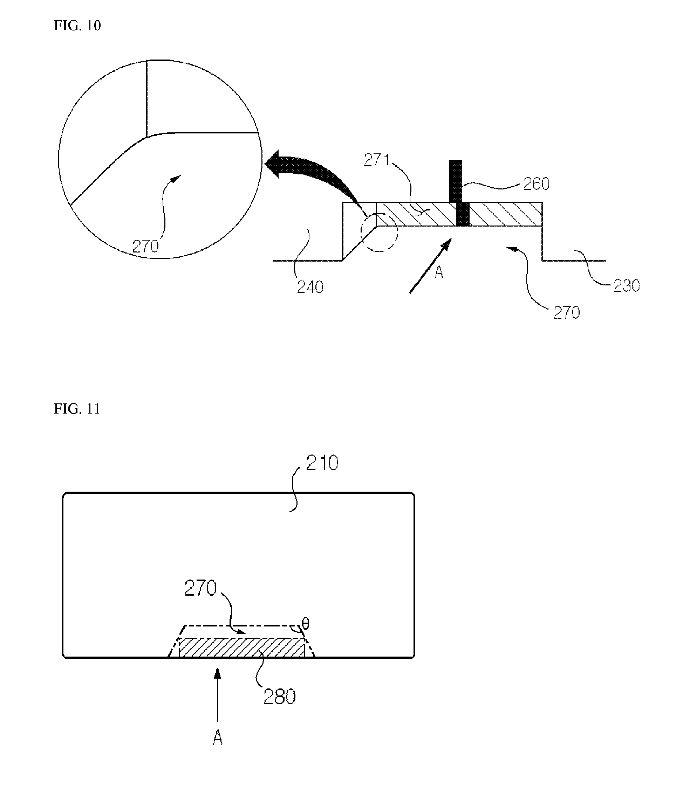

FIGs. 10 and 11 are views illustrating structures of the groove of FIG. 7.

With reference to FIG. 10, inner edges of the groove 270 are rounded, thus preventing the ESD device (not shown) from contacting an inner wall 271 of the groove 270 when the ESD device is inserted into the groove 270 in the direction A.

A space between the ESD device and the inner wall 271 is filled with a soldering material during a subsequent solder reflow process, thereby more firmly connecting the ESD device and the first and second lead frames 230 and 240.

FIG. 11 is a conceptual view of the groove 270, as seen from the top of the light emitting device package 200, and the groove 270 has a trapezoidal shape, the width of which decreases in the direction A.

The width of the groove 270 decreases in the direction A, thereby allowing rectangular corners of the ESD device 280 to be supported by side walls of the trapezoidal groove 270 when the ESD device 280 is inserted into the groove 270.

That is, entry of the ESD device 280 into the groove 280 to more than a designated depth is restricted by the side walls of the trapezoidal groove 270.

The ESD device 280 moving in the direction A using specialized equipment or by a worker enters only up to the designated depth by the side walls, an inclination of which is determined by an angle θ, and is disposed at a designated position in the groove 270.

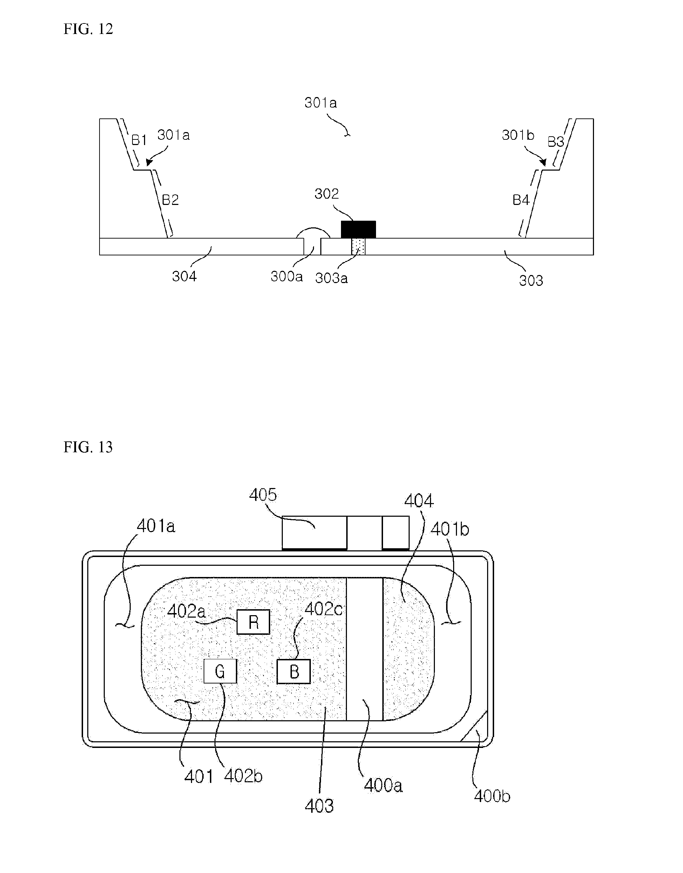

FIG. 12 is a cross-sectional view of the light emitting device package along cavity inclined planes.

With reference to FIG. 12, the cavity inclined planes include a first cavity inclined plane 301a and a second cavity inclined plane 301b, each of which has a multistage structure with a stepped portion.

In this embodiment, the first cavity inclined plane 301a includes two inclined planes B 1 and B2 divided by the stepped portion and serves as a reflecting mirror.

When the first inclined plane B1 and the second inclined plane B2 are extended upwards under the condition that the stepped portion is located there between, the length of the reflecting mirror increases, and that is, convergence of light emitted from a light emitting device 302 is increased in a direction of strengthening central light emitted from the light emitting device 302.

A heat dissipation hole 303a is formed under the light emitting device 302 disposed on a first electrode 303 shown in FIG. 12.

The heat dissipation hole 303a dissipates heat, generated by the light emitting device 302, directly to the outside through the lower end of the light emitting device 302, thereby improving heat dissipation characteristics of the light emitting device 302.

The heat dissipation hole 303a may be formed on one of the body 110, the first lead frame 303 and a second lead frame 304, and is preferably formed under the light emitting device 302.

A protective cap 300a to prevent foreign substances from entering a gap between the first lead frame 303 and the second lead frame 304 is formed between the first lead frame 303 and the second lead frame 304.

The first lead frame 303 and the second lead frame 304 apply positive (+) voltage and negative (-) voltage to the light emitting device 302, and thus need to be separated from each other so as to be electrically insulated from each other.

In order to prevent external foreign substances from entering the gap between the first lead frame 303 and the second lead frame 304, the protective cap 300a is made of a resin material, such as silicon or epoxy.

FIG. 13 is a view illustrating an alignment of light emitting devices in another embodiment.

With reference to FIG. 13, a light emitting device package 400 includes R, G and B light emitting devices 402a, 402b and 402c, a first lead frame 403, a second lead frame 404, a protective cap 400a, a cavity 401, a first cavity inclined plane 401a and a second cavity inclined plane 401b formed by the cavity 401, an ESD device 405 to prevent ESD and to maintain a constant voltage, and a cathode mark 400b to determine polarity.

In this embodiment, the individual R, G and B light emitting devices 402a, 402b and 402c are formed, and white light is formed by mixing light emitted from the R light emitting device 402a, and light emitted from the G light emitting device 402b and light emitted from the B light emitting device 402c. The R, G and B light emitting devices 402a, 402b and 402c individually emit red (R), green (G) and blue (B) light, and thus the cavity 401 is filled with a transparent resin material (not shown) which does not include a phosphor.

If the light emitting device package in accordance with the embodiment shown in FIG. 13 includes only the R light emitting device 402a and the G light emitting device 402b, the resin material needs to include a phosphor to excite blue light so as to form white light. Further, if the light emitting device package includes only the R light emitting device 402a and the B light emitting device 402c, the resin material needs to include a phosphor to excite green light so as to form white light, and if the light emitting device package includes only the G light emitting device 402b and the B light emitting device 402c, the resin material needs to include a phosphor to excite red light so as to form white light.

Two or three light emitting devices may be disposed on the first lead frame 403, and the phosphor included in the resin material is determined according to colors of light emitted from the light emitting devices.

The R, G and B light emitting devices 402a, 402b and 402c are preferably aligned in a triangular shape on the first electrode 403, as shown in FIG. 13, but the alignment shape of the R, G and B light emitting devices 402a, 402b and 402c is not limited thereto.

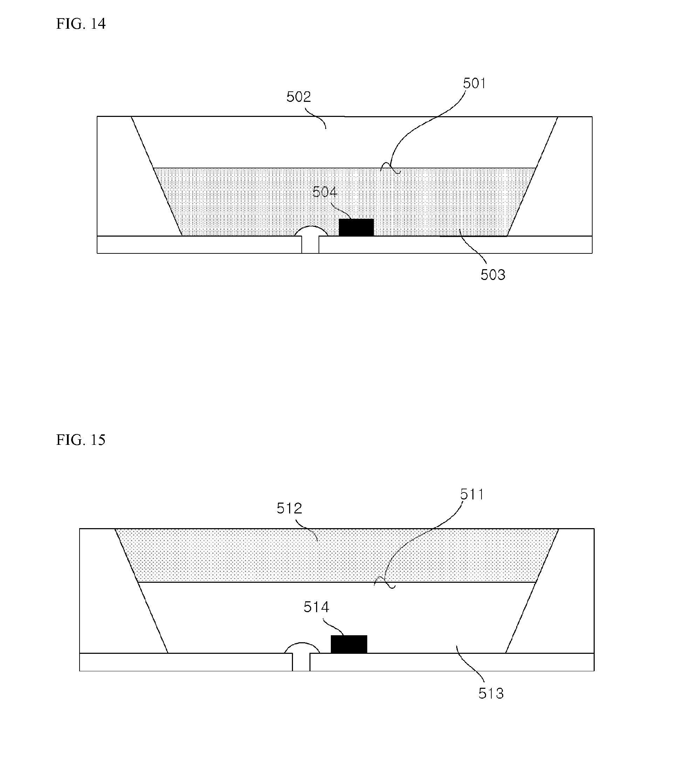

FIGs. 14 to 18 are views illustrating various methods of filling a cavity with resin materials in accordance with embodiments.

First, with reference to FIG. 14, within a cavity 501, a first resin material 503 including a phosphor fills a portion of the cavity 501 in which a light emitting device 504 is disposed, and a second resin material 502 being transparent is stacked on the first resin material 503.

Next, with reference to FIG. 15, within a cavity 511, a first resin material 513 being transparent fills a portion of the cavity 511 in which a light emitting device 514 is disposed, and a second resin material 512 including a phosphor is stacked on the first resin material 513.

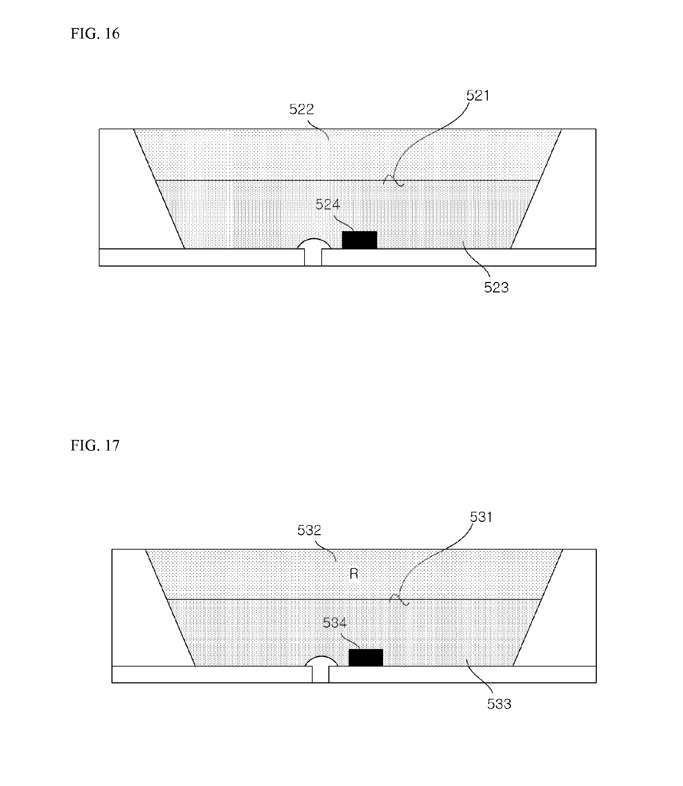

Next, with reference to FIG. 16, a first resin material 523 and a second resin material 522, which include the same phosphor and are sequentially stacked, fill a cavity 521.

In more detail, with reference to FIG. 16, light emitted from a light emitting device 524 passes through the first resin material 523 contacting the light emitting device 524 and the second resin material 522 stacked on the first resin material 523 and is discharged to the outside.

Assuming that the light emitting device 524 is a blue light emitting device to emit blue light, the first resin material 523 and the second resin material 522 include a yellow phosphor.

Here, the first resin material 523 and the second resin material 522 may include different concentrations of the phosphor, and the second resin material 522 may be processed into a lens shape so as to convert characteristics of light emitted from the light emitting device 524 to the outside.

Next, with reference to FIG. 17, a first resin material 533 and a second resin material 532 including two or more phosphors are sequentially stacked.

In more detail, with reference to FIG. 17, if a light emitting device 534 is not a blue light emitting device to emit blue light, two or more phosphors are sequentially stacked within a cavity 531 so as to excite white light.

In FIG. 17, the light emitting device 534 is a green light emitting device to emit green light and the first resin material 533 exciting blue light and the second resin material 532 exciting red light are sequentially stacked on the light emitting device 534 so as to finally excite white light.

If the light emitting device 534 is a red light emitting device to emit red light, the first resin material 533 includes one of a green phosphor and a blue phosphor and the second resin material 532 includes the other one of the green phosphor and the blue phosphor.

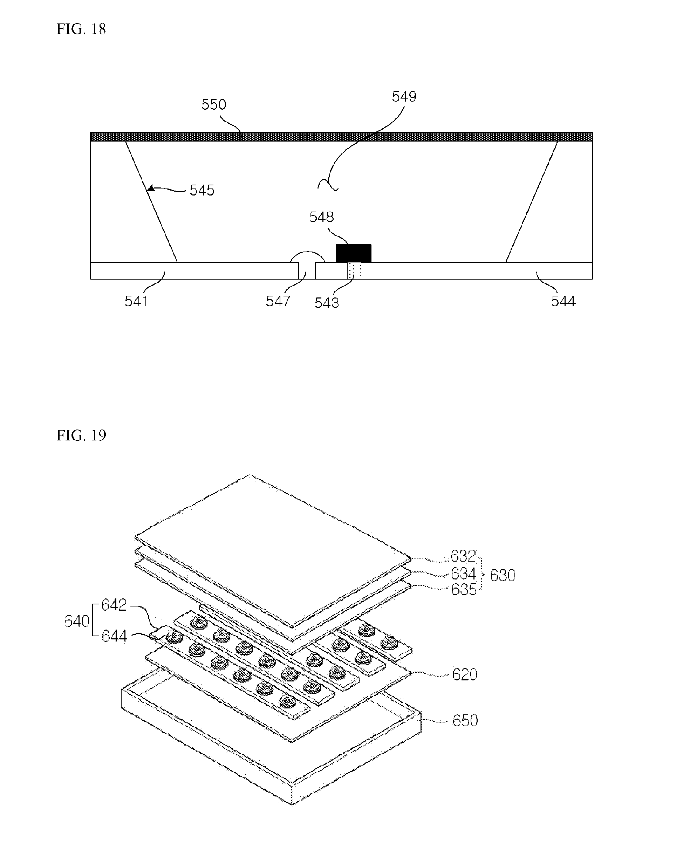

Finally, with reference to FIG. 18, a light emitting device package includes a first lead frame 544, a second lead frame 541, a light emitting device 548 disposed on the first lead frame 544, and a photo luminescent film (PLF) 550 provided on the upper portion of a cavity 549.

The first lead frame 544 and the second lead frame 541 are separated from each other so as to be electrically insulated from each other, and a head cap 547 is formed at the separation region between the first lead frame 544 and the second lead frame 541 so as to prevent external foreign substances from entering the separation region between the first lead frame 544 and the second lead frame 541.

A heat dissipation hole 543 is formed under the light emitting device 548, thereby dissipating heat generated by the light emitting device 548.

The PLF 550 made of a resin including a phosphor is provided on the upper portion of the cavity 549. The PLF 550 includes the phosphor which is excited by light emitting from the light emitting device 548 to form white light. If the light emitting device 548 emits blue light, the PLF 550 includes a yellow phosphor and thus is excited by blue light to form white light.

When the PLF 550 is formed on the upper portion of the cavity 549, a separate phosphor need not be present in the cavity 549. When the PLF 550 is formed on the upper portion of the cavity 549, the cavity 549 may be filled with a transparent resin material.

If light emitted from the light emitting device 548 is red, green or ultraviolet light, the PLF 550 has a multilayer structure. For example, if the light emitting device 548 is a red light emitting device to emit red light, the PLF 550 may be formed as one film including both a blue phosphor and a green phosphor or formed by stacking plural films respectively exciting blue light and green light.

The above-described light emitting devices may be applied to a lighting system including a backlight unit (BLU) or a lighting apparatus, and the lighting system may include an apparatus including light emitting device packages for the purpose of illumination in addition to the backlight unit and the lighting apparatus.

FIG. 19 is a perspective view of one backlight unit including light emitting device packages in accordance with one embodiment.

With reference to FIG. 19, the backlight unit includes a lower receiving member 650, a reflective plate 620, a plurality of light emitting device modules 640, and a plurality of optical sheets 630.

Each of the light emitting device modules 640 includes a printed circuit board 642 and an array of a plurality of light emitting device packages 644 disposed on the printed circuit board 642.

A plurality of protrusions is formed on the bottom surfaces of the light emitting device packages 644, thus improving a mixing effect of red light, green light and blue light if the light emitting device packages 644 emit red, green and blue light so as to form white light.

Of course, if the light emitting device packages 644 emit only white light, the protrusions on the bottom surfaces of the light emitting device packages 644 serve to uniformly disperse the white light.

The reflective plate 620 has high light reflectance, thus being capable of reducing optical loss. The optical sheets 630 may include at least one of a brightness enhancing sheet 632, a prism sheet 634 and a diffusion sheet 636.

The diffusion sheet 636 causes light incident from the light emitting device modules 640 to proceed toward the front surface of a liquid crystal display panel (not shown) and diffuses the light so as to achieve uniform distribution over a wide area and then to irradiate the light onto the liquid crystal display panel (not shown). The prism sheet 634 serves to convert inclined light out of the incident light into vertical light so as to emit the vertical light. That is, in order to convert inclined light out of incident light from the diffusion sheet 636 into vertical light, at least one prism sheet 634 is disposed under the liquid crystal display panel (not shown). The brightness enhancing sheet 632 transmits light which is parallel with a transmission axis thereof and reflects light which is perpendicular to the transmission axis thereof.

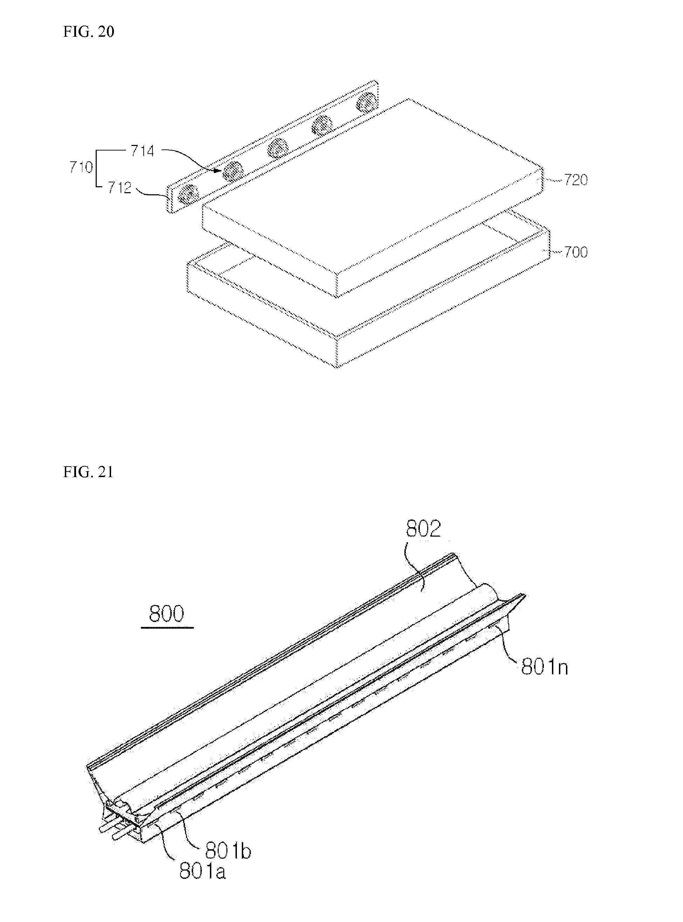

FIG. 20 is a perspective view of another backlight unit including the light emitting device packages in accordance with the embodiment.

With reference to FIG. 20, the backlight unit includes a lower receiving member 700, a light emitting device module 710 to output light, a light guide plate 720 disposed adjacent to the light emitting device module 710, and a plurality of optical sheets (not shown). The plurality of optical sheets (not shown) may be located on the upper surface of the light guide plate 720. The plurality of optical sheets (not shown) is the same as the plurality of optical sheets 630 described in FIG. 19 and a detailed description thereof will thus be omitted.

The light emitting device module 710 includes a printed circuit board 712 and an array of a plurality of light emitting device packages 714 disposed on the printed circuit board 712. A metal core PCB (MCPCB) or a PCB made of FR4 may be used as the printed circuit board 712, but other kinds of PCB may be used as the printed circuit board 712. Further, the printed circuit board 712 may be manufactured to have various shapes as well as a rectangular shape according to the structure of a backlight assembly.

The light guide plate 720 converts light emitted from the light emitting device packages 714 into surface light and then supplies the surface light to a liquid crystal display panel (not shown). The plurality of optical sheets (not shown) to uniformize a brightness distribution of light supplied from the light guide plate 720 and to improve a vertical incident property and a reflective sheet (not shown) to reflect light emitted from the rear portion of the light guide plate 720 back to the light guide plate 720 may be located on the rear surface of the light guide plate 720.

The structure of the vertical type backlight unit described and shown in FIG. 19 and the structure of the edge type backlight unit described and shown in FIG. 20 may be combined.

FIG. 21 is a perspective view of a lighting apparatus including light emitting device packages in accordance with one embodiment.

With reference to FIG. 21, a lighting apparatus 800 includes a shade 802 and light emitting device packages 801a∼801n arranged on one side surface of the shade 802. Although not shown in the drawings, a power supply device to supply power to the respective light emitting device packages 801a∼801n may be provided. The light emitting device package in accordance with the embodiment an ESD device, such as a Zener diode, from absorbing light, as compared with a conventional light emitting device, thus expecting output of a higher quantity of light.

FIG. 21 illustrates a fluorescent lamp type shade. However, the light emitting device in accordance with the embodiment may be applied to a general incandescent lamp type, a fluorescent parallel lamp (FPL) type, a fluorescent lamp type, a halogen lamp type, a metal lamp type and various other types and socket standards, but is not limited thereto.

A lighting system may include the backlight units and the lighting apparatus shown in FIGs. 15 to 17 and an apparatus using the light emitting device package in accordance with the embodiment for the purpose of illumination, but is not limited thereto.

The embodiment has been explained above with reference to characteristic. It will be evident to those skilled in the art that various modifications may be made thereto without departing from the broader spirit and scope of the embodiment. Further, although the embodiment has been described in the context its implementation in particular environments and for particular applications, those skilled in the art will recognize that the present embodiments usefulness is not limited thereto and that the embodiment can be beneficially utilized in any number of environments and implementations. The foregoing description and drawings are, accordingly, to be regarded in an illustrative rather than a restrictive sense.

## Claims

1. A light emitting device package comprising:
a first light emitting device;
a body including a first lead frame on which the first light emitting device is disposed and a second lead frame separated from the first lead frame; and
an ESD device which contacts the first and second lead frames, and at least a part to which is exposed the outside of the body.

2. The light emitting device package of claim 1, wherein the ESD device is at least one selected the group consisting of a TVS, a varistor and a Zener diode.

3. The light emitting device package of claim 1, the first lead frame includes a first protrusion contacting a first plane of the ESD device; and
the second lead frame includes a second protrusion contacting a second plane of the ESD device.

4. The light emitting device package of claim 3, wherein the first protrusion is parallel with the second protrusion.

5. The light emitting device package of claim 3, wherein the first and second protrusion are protruded collinear with side surface of the body or protruded than the side surface of the body.

6. The light emitting device package of claim 3, wherein a first side plane of the first protrusion contacting the first plane is located collinear with a second side plane of the second protrusion contacting the second plane.

7. The light emitting device package of claim 1, wherein a first heat dissipation hole is formed on the first lead frame under the first light emitting device.

8. The light emitting device package of claim 1, further comprising a second light emitting device disposed on the second lead frame,
wherein a second heat dissipation hole is formed on the second lead frame under the second light emitting device.

9. The light emitting device package of claim 1, further comprising a protective cap disposed between the first and second lead frames and electrically insulate the first and second lead frames form each other.

10. The light emitting device package of claim 1, wherein:
a cavity is formed on the first and second lead frames in the body; and the cavity is filled with resin material.

11. The light emitting device package of claim 1, wherein;
a groove formed on the body which to expose a part of each of the first and second lead frames and to the outside; and
the groove is inserted into the ESD device.

12. The light emitting device package of claim 11, wherein the groove is formed correspond to a shape and size of the ESD device.

13. The light emitting device package of claim 11, wherein the exposed parts of the first and second lead frames in the groove are symmetrical with respect to the center between the first and second lead frames.

14. The light emitting device package of claim 11,
wherein the groove has the width decreases in the direction at the center between the first and second lead frames, or has the height increase in the direction at the center between the first and second lead frames.

15. A lighting system comprising a light emitting device package according to any one of claims 1 to 14.
